**Europäisches Patentamt**

**European Patent Office**

**Office européen des brevets**

(11) Veröffentlichungsnummer: **0 251 260**
**A1**

(12) **EUROPÄISCHE PATENTANMELDUNG**

(21) Anmeldenummer: **87109263.1**

(22) Anmeldetag: **27.06.87**

(51) Int. Cl.⁴: **H01L 23/24** , H01L 23/04

(30) Priorität: **01.07.86 DE 3621994**

(43) Veröffentlichungstag der Anmeldung:
**07.01.88 Patentblatt 88/01**

(84) Benannte Vertragsstaaten:
**CH DE FR GB IT LI NL**

(71) Anmelder: **BROWN, BOVERI & CIE**
**Aktiengesellschaft**
**Kallstadter Strasse 1**
**D-6800 Mannheim 31(DE)**

(72) Erfinder: **Nippert, Georg**
**Wasserturmstrasse 10**
**D-6520 Worms/Rhein(DE)**

(74) Vertreter: **Dahlmann, Gerhard, Dipl.-Ing. et al**
**c/o Brown Boveri & Cie., AG Zentralbereich**
**ZPT/P Postfach 351**
**D-6800 Mannheim(DE)**

(54) **Leistungshalbleitermodul.**

㊗ Die Erfindung bezieht sich auf ein Leistungshalbleitermodul mit einem Gehäuse (6), vorzugsweise aus Kunststoff, in das eine Bodenplatte (2), z.B. aus Keramik eingesetzt ist. Das Modul enthält Leistungshalbleiterbauelemente (4) und Anschlußelemente (5) und ist in üblicher Weise sowohl mit einer Weichvergußmasse (9) als auch mit einer Hartvergußmasse (10) vergossen. Damit bei Erwärmung des Moduls (1) und bei einer dadurch herbeigeführten Volumenvergrößerung der Weichvergußmasse (9) Schäden am Modul (1) vermieden werden, wird mit der Erfindung vorgeschlagen, ein Ausgleichsvolumen (8) vorzusehen, in das sich die Weichvergußmasse (9) ausdehnen kann. Es wird dazu außerdem vorgeschlagen, eine Weichvergußmasse (9) zu wählen, die nach dem Aushärten eine ausreichende Restviskosität aufweist, damit das gewünschte Fließverhalten gegeben ist.

## Leistungshalbleitermodul

Die Erfindung bezieht sich auf ein Leistungshalbleitermodul nach dem Oberbegriff des Anspruchs 1.

Die Bodenplatte eines solchen Moduls besteht häufig aus einem keramischen Material, mit einer strukturierten Metallisierung auf der dem Modulinneren zugewandten Oberseite. Eine solche keramische Bodenplatte kann auch auf der Unterseite metallisiert sein. Auf den metallisierten Flächen der Oberseite sind Halbleiterbauelemente, Anschlußelemente für äußere Anschlüsse und evtl. weitere Bauelemente, z.B. für interne Verbindungen, üblicherweise durch Weichlöten befestigt. Zur Herstellung des Moduls wird die bestückte und verlötete Bodenplatte in einer Öffnung in der Bodenfläche eines Kunststoffgehäuses eingeklebt. Das Gehäuse kann z.B. rahmenförmig oder haubenförmig ausgeführt sein. Nach dem Aushärten der Klebung wird in das Modul eines Masse, z.B. ein Silikon für einen Weichverguß bis zu einer gewählten Füllhöhe eingefüllt. Der Weichverguß wird ausgehärtet und anschließend wird das Modul mit einem Hartverguß bis zu einer zweiten gewählten Füllhöhe ausgefüllt.

Es wurde insbesondere bei großflächigen Modulen beobachtet, daß sich die Module im Betrieb oder bereits bei Prüfvorgängen selbst mechanisch zerstören können, wobei die Anschlußelemente für äußere Anschlüsse sich von der Bodenplatte lösen. Es wurde außerdem festgestellt, daß als Ursache für diese Zerstörung der Weichverguß anzusehen ist, der bei Erwärmung eine hohe Volumendehnung von etwa 1 Promille je °C hat.

Bei Temperaturprüfungen, bei denen das Modul nicht auf einen Kühlkörper montiert ist, entsteht durch das Temperaturverhalten des Weichvergusses ein erheblicher Druck im Weichverguß. Da der Hartverguß, in dem die Außenanschlußelemente verankert sind, nicht nachgibt, gibt eine dünn ausgeführte Bodenplatte etwas nach und die Anschlußelemente reißen ab.

Wenn ein Modul mit einer dicken Metallbodenplatte versehen oder auf einen Kühlkörper montiert ist, kann sich die Bodenplatte nicht nach außen wölben. Dann wird bei Erwärmung durch den Druck im Weichverguß das mit dem Hartverguß verbundene Kunststoffgehäuse nach oben weggedrückt, so daß auch in diesem Fall die Anschlüsse an der Bodenplatte abreißen können und außerdem die Klebestelle zwischen Gehäuse und Bodenplatte belastet wird.

Der Erfindung liegt die Aufgabe zugrunde, eine Modulgestaltung anzugeben, bei der die Volumendehnung des Weichvergusses nicht zu Schäden am Modul führt.

Diese Aufgabe wird bei einem Modul nach dem Oberbegriff des Anspruchs 1 durch dessen kennzeichnende Merkmale gelöst.

Das mit der Erfindung vorgeschlagene Ausgleichsvolumen bietet den Vorteil, daß sich die Weichvergußmasse ausdehnen kann und damit hohe Drücke im Modul vermieden werden, die das Modul schädigen könnten. Es bleibt ein durch die Wahl der Größe des Ausgleichsvolumens einstellbarer Restdruck gegeben, der dafür sorgt, daß die Weichvergußmasse beim Abkühlen an den ursprünglichen Ort zurückströmt. Das vorgeschlagene Ausgleichsvolumen kann auf unterschiedliche Weise realisiert werden, z.B. als nach unten hin geöffnete Kammer in einem haubenförmigen Gehäuse, die bei einem Kunststoffgehäuse auf einfache Weise mit Hilfe einer angeformten Trennwand im Gehäuseinnern gebildet werden kann. Das Ausgleichsvolumen kann auch mit Hilfe eines kompressiblen Gebildes geschaffen werden, das in das Modul eingesetzt wird. Auf diese Weise kann auch ohne besondere Gestaltung des Gehäuses die gewünschte Schutzwirkung erzielt werden. Das kompressible Gebilde kann z.B. ein Körper sein, der in sich geschlossene Gasblasen enthält.

Falls man eine Weichvergußmasse wählt, die bereits aufgrund ihres Eigengewichtes fließt, und wenn man verhindern möchte, daß sich das Ausgleichsvolumen bei einer ungünstig gewählten Einbaulage des Moduls mit der Weichvergußmasse füllt, kann vorteilhaft eine elastische Trennwand zwischen einem gasgefüllten Ausgleichsvolumen und der Weichvergußmasse vorgesehen werden.

Schließlich kann nach einer vorteilhaften Ausgestaltung eine Öffnung in der an der Ausgleichsvolumen grenzenden Gehäusewand vorgesehen werden, so daß die Luft in dem Ausgleichsvolumen mit der Außenluft, die das Leistungshalbleitermodul umgibt, in Verbindung steht und somit das Leistungshalbleitermodul "atmen" kann.

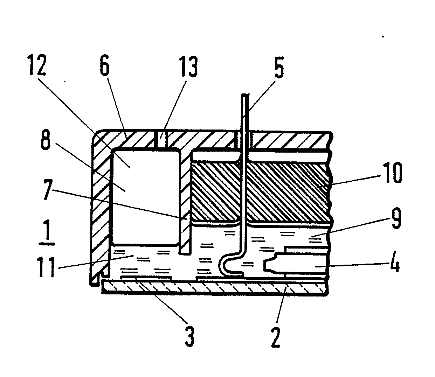

Ein Ausführungsbeispiel wird nachstehend anhand der Zeichnung erläutert.

Die Zeichnung zeigt einen Teil eines Leistungshalbleitermoduls 1. Eine keramische Bodenplatte 2 weist auf der dem Modulinneren zugewandten Oberseite eine Metallisierung 3 auf, die strukturiert ist zu Leiterbahnen und zu Flächen, auf die Halbleiterbauelemente 4, Anschlußelemente 5 für äußere Anschlüsse und ggf. weitere Bauelemente aufgelötet sind. Die Bodenplatte 2 ist in ein Kunststoffgehäuse 6 eingeklebt. Im haubenförmigen Gehäuse 6 ist mit Hilfe einer Trennwand 7 eine nach unten geöffnete Kammer 12 gebildet zur Schaffung eines Ausgleichsvolumens 8, das mit Luft gefüllt ist. Das Modul 1 wird durch eine nicht dargestellte Öffnung in der Oberseite zunächst mit einer Weichvergußmasse 9 bis zu einer gewählten Füllhöhe gefüllt. Nach dem Aushärten der Weichvergußmasse 9 wird das Modul 1 mit einer Hartvergußmasse 10 vollständig oder bis zu einer zweiten gewählten Füllhöhe ausgefüllt.

Beim Einfüllen der Weichvergußmasse 9 steigt diese in der Kammer 12 durch die Öffnung 11 nur bis zu einer geringen Höhe an, da die Luft in der Kammer 12 einen Gegendruck bewirkt.

Als Weichvergußmasse 9 ist z.B. ein Silikonweichverguß Vp 7612 geeignet. Die gelartige Vergußmasse muß jedenfalls nach dem Aushärten eine ausreichende Restviskosität besitzen. Bei betriebsmäßiger Erwärmung des Moduls 1 stellt sich im Modul 1 ein hydrostatischer Druck ein, der durch die Wahl der Größe des Ausgleichsvolumens 8 beeinflußt werden kann. Als Hartvergußmasse 10 wird zweckmäßig in üblicher Weise ein Hartverguß auf Epoxidbasis gewählt.

Unter extremen Bedingungen, z.B. im Rahmen von Qualitätstests, kann es erforderlich sein, das Modul auf eine höhere Temperatur, z.B. bis 250°C zu erwärmen, wobei der Druck in dem Ausgleichsvolumen hohe Werte annehmen kann. Um auch in diesem Fall einer Zerstörung des Moduls vorzubeugen, kann es vorteilhaft sein, in der das Ausgleichsvolumen umgebenden Wand eine Öffnung 13 vorzusehen, wie in der Zeichnung dargestellt. Über eine solche Öffnung 13, die bevorzugt an der Oberseite des Gehäuses 6 angeordnet ist, kann ein Druckausgleich erfolgen. In den Raum des Ausgleichsvolumens 8 wird jedoch auch bei oben offener Ausführung keine Hartvergußmasse 10 eingefüllt.

## Ansprüche

1. Leistungshalbleitermodul mit einem Gehäuse, in das als Gehäuseboden eine Bodenplatte eingesetzt ist, die auf der dem Gehäuseinneren zugewandten Oberseite aufgelötete Bauelemente und elektrische Anschlußelemente aufweist, wobei das Gehäuse bis zu einer gewählten Füllhöhe mit einer Weichvergußmasse und darüber mit einer Hartvergußmasse ausgegossen ist, dadurch gekennzeichnet, daß ein Ausgleichsvolumen (8) vorgesehen ist, das mit dem von der Weichvergußmasse (9) ausgefüllten Volumen in Verbindung steht und daß als Weichvergußmasse (9) eine gelartige Substanz gewählt ist, die nach dem Aushärten eine ausreichende Restviskosität besitzt, damit sich die Weichvergußmasse (9) bei Erwärmung in das Ausgleichsvolumen (8) hinein ausdehnt.

2. Leistungshalbleitermodul nach Anspruch 1, dadurch gekennzeichnet, daß das Ausgleichsvolumen (8) als mindestens eine luftgefüllte Kammer (12) innerhalb des Gehäuses (6) ausgebildet ist, mit einer von der Weichvergußmasse (9) bedeckten Öffnung (11).

3. Leistungshalbleitermodul nach Anspruch 1, dadurch gekennzeichnet, daß das Ausgleichsvolumen (8) durch ein in die Vergußmassen (9,10) eingebettetes kompressibles Gebilde realisiert ist.

4. Leistungshalbleitermodul nach einem der Ansprüche 1 bis 3, dadurch gekennzeichnet, daß zwischen dem Ausgleichsvolumen (8) und der Weichvergußmasse (9) eine elastische Trennwand vorgesehen ist.

5. Leistungshalbleitermodul nach einem der Ansprüche 1 bis 4, dadurch gekennzeichnet, daß das Gehäuse (6) aus Kunststoff besteht.

6. Leistungshalbleitermodul nach einem der Ansprüche 1 bis 5, dadurch gekennzeichnet, daß die Bodenplatte (2) aus einem keramischen Material besteht.

7. Leistungshalbleitermodul nach einem der Ansprüche 1 bis 5, dadurch gekennzeichnet, daß die Bodenplatte (2) aus Kupfer besteht.

8. Leistungshalbleitermodul nach einem der Ansprüche 1 bis 7, dadurch gekennzeichnet, daß die Bodenplatte (2) in das Gehäuse (6) eingeklebt ist.

9. Leistungshalbleitermodul nach Anspruch 6, dadurch gekennzeichnet, daß die keramische Bodenplatte (2) wenigstens auf der Oberseite mit einer metallischen Beschichtung versehen ist, wobei die Metallisierung (3) auf der Oberseite strukturiert ist.

10. Leistungshalbleitermodul nach einem der Ansprüche 1, 2 und 4 bis 9, dadurch gekennzeichnet, daß das Ausgleichsvolumen (8) über eine Öffnung (13) im Gehäuse (6) mit der das Leistungshalbleitermodul umgebenden Luft in Verbindung steht.

## EUROPÄISCHER RECHERCHENBERICHT

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | PATENT ABSTRACTS OF JAPAN, Band 9, Nr. 325 (E-368)[2048], 20. Dezember 1985; & JP-A-60 157 241 (MITSUBISHI DENKI K.K.) 17-08-1985 * Zusammenfassung * | 1 | H 01 L 23/24 H 01 L 23/04 |
| A | Idem | 2,8,9 | |
| | --- | | |
| X | PATENT ABSTRACTS OF JAPAN, Band 8, Nr. 119 (E-248)[1556], 5. Juni 1984; & JP-A-59 31 044 (MITSUBISHI DENKI K.K.) 18-02-1984 * Zusammenfassung * | 1 | |
| A | Idem | 2,5,7, 9,10 | RECHERCHIERTE SACHGEBIETE (Int. Cl.4) |
| | --- | | H 01 L |
| P,X | PATENT ABSTRACTS OF JAPAN, Band 10, Nr. 209 (E-421)[2265], 22. Juli 1986; & JP-A-61 48 947 (MITSUBISHI ELECTRIC CORP.) 10-03-1986 * Zusammenfassung * | 1 | |
| A | Idem | 2,6,9 | |
| | --- -/- | | |

Der vorliegende Recherchenbericht wurde für alle Patentansprüche erstellt.

| Recherchenort | Abschlußdatum der Recherche | Prüfer |
|---|---|---|
| DEN HAAG | 01-10-1987 | DE RAEVE R.A.L. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PATENT ABSTRACTS OF JAPAN, Band 10, Nr. 283 (E-440)[2339], 26. September 1986; & JP-A-61 101 056 (HITACHI MICRO COMPUT ENG LTD) 19-05-1986 ----- | 1,2,4, 8,9 | |

RECHERCHIERTE SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| DEN HAAG | 01-10-1987 | DE RAEVE R.A.L. |

EPA Form 1503 03 82